# EUROPEAN PATENT APPLICATION

(11) **EP 4 615 184 A1**
(43) Date of publication of application: **10.09.2025**
(21) Application number: 25161606.6
(22) Date of filing: 04.03.2025
(51) Int. Cl.: H05K 7/20, H01L 23/427

(54) **POWER CONVERSION APPARATUS, PHOTOVOLTAIC SYSTEM, AND HEAT SINK**

(30) Priority: 07.03.2024 CN 202410265892
(71) Applicant: Huawei Digital Power Technologies Co., Ltd., Shenzhen, Guangdong 518043 (CN)
(72) Inventor: Ren, Junheng, Shenzhen, 518129 (CN); Li, Jiyang, Shenzhen, 518129 (CN); Hong, Fangjun, Shenzhen, 518129 (CN)
(74) Representative: Epping - Hermann - Fischer

(57) **Abstract**

This application provides a power conversion apparatus, a photovoltaic system, and a heat sink, and relates to the field of energy technologies, to resolve a problem of poor heat dissipation performance of the power conversion apparatus. The power conversion apparatus provided in this application includes a heat sink and a power module. The heat sink includes a plurality of condensation teeth and an evaporator. The plurality of condensation teeth are spaced apart from each other in a thickness direction of the condensation tooth, and an airflow channel parallel to a second direction is provided between two adjacent condensation teeth. Each condensation tooth has a condensation channel and a solid region that extend in a first direction, and the condensation channel is located on a side of the solid region. The first direction, the second direction, and the thickness direction are perpendicular to each other. In the power conversion apparatus provided in this application, the solid region has a good thermal conductivity, and heat of the evaporator can be effectively transferred to the condensation tooth through the solid region. This can effectively reduce consumption of a cooling working medium, and avoid a problem of insufficiency of the cooling working medium. Therefore, the power conversion apparatus has good heat dissipation performance.

## Description

### TECHNICAL FIELD

This application relates to the field of energy technologies, and in particular, to a power conversion apparatus, a photovoltaic system, and a heat sink.

### BACKGROUND

With continuous development and wide application of green energy, importance of electric energy in people's daily life has become increasingly prominent. In a process of transmitting or using electric energy, a parameter like a voltage or a current of the electric energy needs to be converted or adjusted. For example, a photovoltaic power generation device may include a solar panel and an inverter. The solar panel can convert solar energy into a direct current, and the inverter can convert the direct current generated by the solar panel into an alternating current and then output the alternating current to the outside. During actual use, the inverter generates a large amount of heat. Therefore, heat needs to be dissipated for the inverter, to ensure operating performance and reliability of the inverter. Currently, air cooling is mainly used to dissipate heat for the inverter. In simple terms, a heat sink may be disposed on an outer surface of the inverter, heat of the inverter can be conducted to the heat sink through heat transfer, and external airflow can take away the heat of the heat sink when flowing through a surface of the heat sink, to cool the inverter. However, as operating power of the inverter continuously increases, heat dissipation requirements of the inverter also significantly increase. Consequently, simply using the air cooling heat sink to dissipate heat for the inverter cannot satisfy a heat dissipation requirement of the inverter. Therefore, how to improve heat dissipation performance of the heat sink becomes an urgent technical problem to be resolved.

### SUMMARY

This application provides a power conversion apparatus, a photovoltaic system, and a heat sink that have good heat dissipation performance.

According to a first aspect, this application provides a power conversion apparatus, including a heat sink and a power module. The heat sink includes a plurality of condensation teeth and an evaporator, and each condensation tooth extends in a first direction. The plurality of condensation teeth are spaced apart from each other in a thickness direction of the condensation tooth, and an airflow channel in a second direction is provided between two adjacent condensation teeth. The first direction, the second direction, and the thickness direction are all perpendicular to each other. Each condensation tooth has a condensation channel and a solid region. Both the condensation channel and the solid region extend in the first direction, and condensation channels are located on a same side of the solid region in the second direction. The evaporator has an evaporation cavity, and each condensation channel communicates with the evaporation cavity. The evaporator has a first surface and a second surface that are opposite to each other, and both the first surface and the second surface are perpendicular to the first direction. An end of each condensation tooth in the first direction is connected to the first surface, the power module is attached to the second surface, and a projection of the power module in the first direction overlaps the solid region.

In the power conversion apparatus provided in this application, the evaporation cavity accommodates the cooling working medium, and heat generated by the power module can be conducted to the evaporator in a heat transfer manner. The cooling working medium in the evaporation cavity flows into the condensation channel after being heated and gasified, so that the power module can be effectively cooled. In addition, during actual application, the airflow channel may be parallel to a gravity direction (the second direction). According to a principle that hot air rises, a flow speed of air in the airflow channel is increased, and heat dissipation efficiency of the heat sink is improved. The condensation tooth further includes the solid region, and the solid region has a good thermal conductivity. Therefore, heat of the evaporator can be further effectively transferred to the condensation tooth through the solid region. In addition, the projection of the power module in the first direction overlaps the solid region, so that heat generated by the power module can be transferred to the solid region through a short heat conduction path. This improves heat transfer efficiency of the heat sink. In addition, the condensation channel is located on a side of the solid region in the second direction. Therefore, during actual use, when the condensation channel is located on an upper side of the solid region, consumption of the cooling working medium can be effectively reduced, and a problem of insufficiency of the cooling working medium can be avoided.

In an example, in a cross section perpendicular to an extension direction (namely, the first direction) of the condensation channel, a ratio of a size of the condensation channel in the second direction (for example, the gravity direction) to a size of the condensation channel in the thickness direction (for example, a horizontal direction) is greater than or equal to 3. In this way, the cooling working medium can better implement condensation and backflow in the condensation channel, and has better cooling performance.

In an example, the solid region further has a cavity, and the cavity may be a closed cavity or an open cavity. When the cavity is an open cavity, the cavity may communicate with the evaporation cavity. Alternatively, it may be understood that, during specific disposing, the solid region may include only a solid material, or may include a cavity structure. After a flow channel communicates with the evaporation cavity, the cavity can store and release the cooling working medium, to avoid the problem of the insufficiency of the cooling working medium in the heat sink.

In an example, the condensation tooth further has a liquid collection cavity, and the liquid collection cavity communicates with the evaporation cavity. The liquid collection cavity is located on a side that is of the solid region and that is away from the condensation channel. For example, during actual use, the liquid collection cavity may be located on a lower side of the solid region, so that the liquid collection cavity can store and release the cooling working medium, to avoid the problem of the insufficiency of the cooling working medium in the heat sink.

In an example, the evaporator includes a first side wall and a second side wall. The first side wall and the second side wall are disposed opposite to each other in the first direction, and the evaporation cavity is located between the first side wall and the second side wall. An end of the condensation tooth is connected to the first side wall, and the power module may be attached to a surface of the second side wall. The evaporation cavity includes a thermally conductive rib, one end of the thermally conductive rib is connected to the first side wall, and the other end is connected to the second side wall. Heat of the second side wall may be effectively transferred to the first side wall through the thermally conductive rib, so that heat transfer efficiency and temperature uniformity of the evaporator can be effectively improved. In addition, the thermally conductive rib is connected between the first side wall and the second side wall, so that structural strength of the evaporator can be further effectively improved.

In an example, a flow channel is formed between two adjacent thermally conductive ribs, and the two adjacent flow channels communicate with each other, so that flow efficiency of the cooling working medium in the evaporation cavity can be ensured.

During specific disposing, the thermally conductive rib is in a long strip shape and extends in the second direction. Alternatively, the thermally conductive rib is a protrusion, and a plurality of protrusions are spaced apart from each other in the evaporation cavity.

In an example, the heat sink further includes a heat dissipation fin, and the heat dissipation fin is located in the airflow channel and is connected to an outer surface of the condensation fin. Heat in the condensation fin can be conducted to the heat dissipation fin for dissipation, and the heat dissipation fin has a large heat exchange area. This can improve heat dissipation performance of the heat sink.

In an example, the heat sink further includes a confluence plate, the confluence plate is disposed opposite to the evaporator, and the plurality of condensation teeth are connected between the evaporator and the confluence plate. The confluence plate has a condensation confluence cavity, and the condensation channel communicates with the condensation confluence cavity. The cooling working medium condensed in the condensation channel may flow to the condensation confluence cavity, so that backflow efficiency of the liquid cooling working medium can be improved.

In an example, the power conversion apparatus includes a plurality of heat sinks, and the plurality of heat sinks are stacked in the second direction, or are stacked in the first direction. Alternatively, when the power conversion apparatus includes more than three heat sinks, the heat sinks may be disposed in the second direction, or may be disposed in the first direction.

In an example, the plurality of heat sinks include a first heat sink and a second heat sink, and the first heat sink and the second heat sink are stacked in the second direction. For example, during actual use, the first heat sink may be located on an upper side of the second heat sink. A projection of an airflow channel of the first heat sink in the second direction (for example, the gravity direction) is greater than a projection of an airflow channel of the second heat sink in the gravity direction. That is, air flowing through the airflow channel of the first heat sink may be divided into two parts. A part of air flows through the airflow channel of the second heat sink and then flows through the airflow channel of the first heat sink. The other part of air directly flows from the outside through the airflow channel of the first heat sink.

In an example, the plurality of heat sinks include a first heat sink and a second heat sink, and the first heat sink and the second heat sink are stacked in the second direction. For example, during actual use, the first heat sink may be located on an upper side of the second heat sink. The first heat sink further includes first heat dissipation fins, and the first heat dissipation fin is located in the airflow channel of the first heat sink. The second heat sink further includes second heat dissipation fins, and the second heat dissipation fin is located in the airflow channel of the second heat sink. A layout density of the first heat dissipation fins is greater than a layout density of the second heat dissipation fins. After the layout density of the second heat dissipation fins is small, resistance of air flowing through the second heat dissipation fin can be decreased, so that air still has a high circulation speed when flowing through the first heat dissipation fin. In addition, after the arrangement density of the first heat dissipation fins is large, a heat exchange area between the first heat dissipation fin and air can be increased, and heat dissipation efficiency of the first heat sink can be ensured. In addition, temperature uniformity between the first heat sink and the second heat sink can be further ensured.

In an example, the evaporator has a first positioning protrusion or a first positioning groove, the condensation tooth has a second positioning groove or a second positioning protrusion, and the first positioning protrusion is inserted into the second positioning groove, or the second positioning protrusion is inserted into the first positioning groove. Precision and reliability of a connection between the condensate tooth and the evaporator can be improved through positioning cooperation between the first positioning protrusion and the second positioning groove or positioning cooperation between the first positioning groove and the second positioning protrusion.

In an example, the power conversion apparatus is a rectifier or an inverter.

According to a second aspect, this application further provides a photovoltaic system. The photovoltaic system may include a photovoltaic power generation device and the foregoing power conversion apparatus. The power conversion apparatus is connected to the photovoltaic power generation device, and is configured to convert a direct current generated by the photovoltaic power generation device into an alternating current. The foregoing power conversion apparatus can be configured to effectively cool a power module, and an adverse situation like performance deterioration caused by an excessively high temperature of the power module can be prevented. In this way, working performance and safety of the photovoltaic system are ensured.

According to a third aspect, this application further provides a heat sink, including a plurality of condensation teeth and an evaporator. The plurality of condensation teeth are spaced apart from each other in a thickness direction of the condensation tooth, and an airflow channel in a second direction is provided between two adjacent condensation teeth. The first direction, the second direction, and the thickness direction are all perpendicular to each other. Each condensation tooth has a condensation channel and a solid region. Both the condensation channel and the solid region extend in the first direction, and condensation channels are located on a same side of the solid region in the second direction. The evaporator has an evaporation cavity, and each condensation channel communicates with the evaporation cavity. The evaporator has a first surface and a second surface that are opposite to each other, and both the first surface and the second surface are perpendicular to the first direction. An end of each condensation tooth in the first direction is connected to the first surface.

In the heat sink provided in this application, the evaporation cavity accommodates a cooling working medium, and heat generated by the power module can be conducted to the evaporator in a heat transfer manner. The cooling working medium in the evaporation cavity flows into the condensation channel after being heated and gasified, so that the heat sink can be effectively cooled. In addition, during actual application, the airflow channel may be parallel to a gravity direction (the second direction). According to a principle that hot air rises, a flow speed of air in the airflow channel is increased, and heat dissipation efficiency of the heat sink is improved. The condensation tooth further includes the solid region, and the solid region has a good thermal conductivity. Therefore, heat of the evaporator can be further effectively transferred to the condensation tooth through the solid region. In addition, the condensation channel is located on a side of the solid region in the second direction. Therefore, during actual use, when the condensation channel is located on an upper side of the solid region, consumption of the cooling working medium can be effectively reduced, and a problem of insufficiency of the cooling working medium can be avoided.

In an example, in a cross section perpendicular to an extension direction (namely, the first direction) of the condensation channel, a ratio of a size of the condensation channel in the second direction (for example, the gravity direction) to a size of the condensation channel in the thickness direction (for example, a horizontal direction) is greater than or equal to 3. In this way, the cooling working medium can better implement condensation and backflow in the condensation channel, and has better cooling performance.

In an example, the solid region further has a cavity, and the cavity may be a closed cavity or an open cavity. When the cavity is an open cavity, the cavity may communicate with the evaporation cavity. Alternatively, it may be understood that, during specific disposing, the solid region may include only a solid material, or may include a cavity structure. After a flow channel communicates with the evaporation cavity, the cavity can store and release the cooling working medium, to avoid the problem of the insufficiency of the cooling working medium in the heat sink.

In an example, the condensation tooth further has a liquid collection cavity, and the liquid collection cavity communicates with the evaporation cavity. The liquid collection cavity is located on a side that is of the solid region and that is away from the condensation channel. For example, during actual use, the liquid collection cavity may be located on a lower side of the solid region, so that the liquid collection cavity can store and release the cooling working medium, to avoid the problem of the insufficiency of the cooling working medium in the heat sink.

### BRIEF DESCRIPTION OF DRAWINGS

FIG. 1 is a simple diagram of a structure of a conventional photovoltaic power generation device according to an embodiment of this application;
FIG. 2 is a diagram of a three-dimensional structure of a power conversion apparatus according to an embodiment of this application;
FIG. 3 is a diagram of a cross-sectional structure along A-A in FIG. 2;
FIG. 4 is a diagram of a cross-sectional structure of a power conversion apparatus according to an embodiment of this application;
FIG. 5 is a diagram of another cross-sectional structure of a power conversion apparatus according to an embodiment of this application;
FIG. 6 is a diagram of another cross-sectional structure of a power conversion apparatus according to an embodiment of this application;
FIG. 7 is a diagram of another cross-sectional structure of a power conversion apparatus according to an embodiment of this application;
FIG. 8 is a diagram of a three-dimensional structure of an evaporator according to an embodiment of this application;
FIG. 9 is a diagram of a cross-sectional structure along B-B in FIG. 8;
FIG. 10 is a diagram of another three-dimensional structure of an evaporator according to an embodiment of this application;
FIG. 11 is a diagram of another three-dimensional structure of an evaporator according to an embodiment of this application;
FIG. 12 is a diagram of a three-dimensional structure of a power conversion apparatus according to an embodiment of this application;
FIG. 13 is a diagram of a cross-sectional structure along C-C in FIG. 12;
FIG. 14 is a diagram of a three-dimensional structure of a power conversion apparatus according to an embodiment of this application;
FIG. 15 is a diagram of an exploded structure of a heat sink according to an embodiment of this application;
FIG. 16 is a diagram of another exploded structure of a heat sink according to an embodiment of this application;
FIG. 17 is a diagram of a side structure of a power conversion apparatus according to an embodiment of this application;
FIG. 18 is a diagram of another side structure of a power conversion apparatus according to an embodiment of this application;
FIG. 19 is a diagram of another three-dimensional structure of a power conversion apparatus according to an embodiment of this application;
FIG. 20 is a diagram of another three-dimensional structure of a power conversion apparatus according to an embodiment of this application;
FIG. 21 is a diagram of another three-dimensional structure of a power conversion apparatus according to an embodiment of this application;
FIG. 22 is a diagram of another three-dimensional structure of a power conversion apparatus according to an embodiment of this application;
FIG. 23 is a diagram of another cross-sectional structure of a power conversion apparatus according to an embodiment of this application; and
FIG. 24 is a block diagram of a structure of a photovoltaic system according to an embodiment of this application.

### DESCRIPTION OF EMBODIMENTS

To make the objectives, technical solutions, and advantages of this application clearer, the following further describes this application in detail with reference to the accompanying drawings.

For ease of understanding a heat sink provided in embodiments of this application, the following first describes an application scenario of the heat sink.

The heat sink provided in embodiments of this application may be applied to a plurality of scenarios in which there is a heat dissipation requirement. For example, the heat sink may be used in a power conversion apparatus, in other words, the power conversion apparatus may include the heat sink and a power module. The heat sink may be configured to cool the power module, so that the power module is in a normal temperature range, to ensure working performance and safety of the power module.

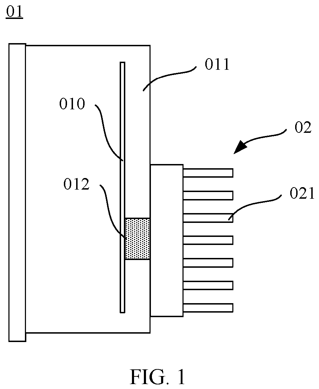

For example, as shown in FIG. 1, a photovoltaic power generation device may include a power conversion apparatus 01. The power conversion apparatus 01 can convert a direct current generated by a solar panel into an alternating current and then output the alternating current to the outside. During actual use, the power conversion apparatus 01 may include a power module 011 and a heat sink 02. The power module 011 includes power components such as a circuit board 010 and a power transistor 012. The power transistor 012 is electrically connected to a conductive line in the circuit board 010. During actual application, the power module 011 generates a large amount of heat. Therefore, heat needs to be dissipated for the power module 011, to ensure operating performance and reliability of the power module 011. Currently, air cooling is mainly used to dissipate heat for the power module 011. In simple terms, the heat sink 02 can be disposed at a position, on the power module 011, corresponding to the power transistor 012. The heat sink 02 may include heat dissipation fins 021. An airflow can quickly take away heat of the heat dissipation fins 021 when flowing through gaps between the heat dissipation fins 021, to cool the power module 011. In summary, heat generated by the power module 011 can be transferred to the heat dissipation fins 021 of the heat sink 02 through heat conduction, and an airflow flowing through the heat dissipation fins 021 can quickly take away heat of the heat sink 02, to cool the power module 011.

However, as operating power of the power module 011 continuously increases, heat dissipation requirements of the power module 011 also significantly increase. Consequently, simply using the air cooling heat sink 02 to dissipate heat for the power module 011 cannot satisfy a heat dissipation requirement of the power module 011.

Therefore, embodiments of this application provide a heat sink with good heat dissipation performance and a power conversion apparatus equipped with the heat sink.

To make the objectives, technical solutions, and advantages of this application clearer, the following further describes this application in detail with reference to the accompanying drawings and specific embodiments.

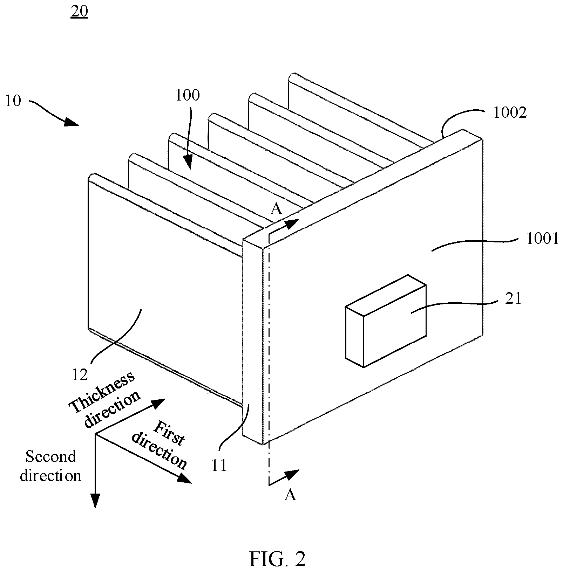

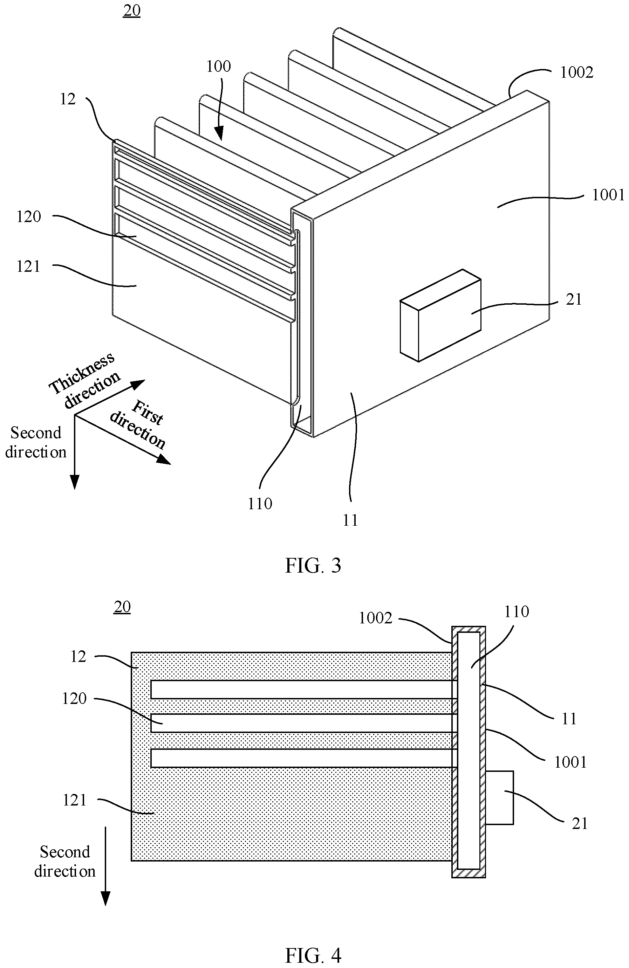

As shown in FIG. 2 and FIG. 3, in an example provided in this application, a power conversion apparatus 20 includes a heat sink 10 and a power module 21. It should be noted that the power module 21 may be specifically a chip, a component, a package body, or the like that is in the power conversion apparatus 20 and that is configured to implement power conversion. Alternatively, the power module 21 is a heat source that needs to be cooled in the power conversion apparatus 20. A specific structural form and type of the power module 21 are not limited in this application. In addition, the heat sink 10 includes a plurality of condensation teeth 12 (six condensation teeth are shown in the figure) and an evaporator 11. The plurality of condensation teeth 12 are parallel to each other and are spaced apart from each other in a thickness direction of the condensation tooth 12, and an airflow channel 100 parallel to a second direction is formed between two adjacent condensation teeth 12. For example, when the second direction is consistent with a gravity direction, both the top and the bottom of the airflow channel 100 communicate with the outside; and external air may enter the airflow channel 100 from the bottom of the airflow channel 100, and be discharged from the top of the airflow channel 100. As shown in FIG. 3, each condensation tooth 12 has a condensation channel 120 and a solid region 121. Both the condensation channel 120 and the solid region 121 extend in a first direction, and the condensation channel 120 is located on a side of the solid region 121. The evaporator 11 has an evaporation cavity 110, and each condensation channel 120 communicates with the evaporation cavity 110. An outer surface of the evaporator 11 includes a first surface 1001 and a second surface 1002 that are opposite to each other, and both the first surface 1001 and the second surface 1002 are perpendicular to the first direction. An end of each condensation tooth 12 in the first direction is connected to the first surface 1001, the power module 21 is attached to the second surface 1002, and a projection of the power module 21 in the first direction overlaps the solid region 121.

Specifically, the evaporation cavity 110 accommodates a cooling working medium. The cooling working medium may be specifically a medium, for example, Freon, that can generate gas-liquid two-phase conversion. A specific type of the cooling working medium is not limited in this application. Heat generated by the power module 21 can be conducted to the evaporator 11. The cooling working medium in the evaporation cavity 110 flows to the condensation channel 120 after being heated and gasified. The gasified cooling working medium is cooled and liquefied when flowing in the condensation channel 120, and may flow back to the evaporation cavity 110, so that the cooling working medium circulates in the evaporation cavity 110 and the condensation channel 120, and the power module 21 can be effectively cooled. In addition, during actual use, the airflow channel 100 may be parallel to the gravity direction, in other words, the second direction is parallel to the gravity direction. Therefore, external air may enter the airflow channel 100 from the bottom of the airflow channel 100, and be discharged from the top of the airflow channel 100. When external air flows through the airflow channel 100, the air is heated by the condensation tooth 12, and a temperature of the air gradually increases. According to a principle that hot air rises, after the airflow channel 100 is parallel to the gravity direction, a flow speed of air in the airflow channel 100 is increased. This improves heat dissipation efficiency of the heat sink 10.

In addition, as shown in FIG. 3, the condensation tooth 12 includes the condensation channel 120 and the solid region 121. Heat of the evaporator 11 may be transferred to the condensation tooth 12 in two manners: gas-liquid conversion and heat transfer of the cooling working medium, so that heat transfer efficiency is good. Specifically, the liquid cooling working medium in the evaporation cavity 110 is gasified after being heated and enters the condensation channel 120. When external air flows through the airflow channel 100, a temperature of the condensation tooth 12 can be effectively reduced. Therefore, the gaseous cooling working medium can be cooled and liquefied in the condensation channel 120. In other words, heat in the evaporator 11 may be transferred to the condensation tooth 12 through the cooling working medium. In addition, the condensation tooth 12 further includes the solid region 121, and the solid region 121 has a good thermal conductivity. Therefore, heat of the evaporator 11 can be further effectively transferred to the condensation tooth 12 through the solid region 121.

As shown in FIG. 3, in the example provided in this application, the condensation channel 120 is located on the side of the solid region 121 in the second direction. For example, during actual use, after the second direction is parallel to the gravity direction, the condensation channel 120 may be located on an upper side of the solid region 121. Therefore, consumption of the cooling working medium can be effectively reduced, and a problem of insufficiency of the cooling working medium can be avoided. Alternatively, it may be understood that the liquid cooling working medium flows downward under an action of gravity. In the example provided in this application, the solid region 121 in the condensation tooth 12 is located on a lower side of the condensation channel 120, and the solid region 121 significantly occupies internal space of the condensation tooth 12. In this way, a larger amount of cooling working medium can enter the condensation channel 120 and the evaporation cavity 110. Therefore, during actual application, a problem of insufficient cooling working medium in the condensation channel 120 and the evaporation cavity 110 can be avoided. In addition, when consumption of the cooling working medium is small, the problem of the insufficiency of the cooling working medium in the condensation channel 120 and the evaporation cavity 110 can also be effectively reduced or avoided.

Alternatively, it may be understood that, disposing of the solid region 121 can effectively increase a size of the condensation tooth 12, so that a heat exchange area between the condensation tooth 12 and external air is increased, and heat dissipation efficiency of the heat sink 10 is improved.

It should be noted that, in the foregoing example, an example in which the solid region 121 includes only a thermally conductive material is used for description. For example, the solid region 121 may be a solid metal body made of copper, aluminum, or an alloy material. Alternatively, it may be understood that the entire condensation tooth 12 may be made of copper, aluminum, or an alloy material, so that the entire condensation tooth 12 has a good thermal conductivity and structural strength.

During specific disposing, the heat sink 10 may include two, three, or more condensation teeth 12. For ease of understanding the technical solutions of this application, the following uses an example in which the heat sink 10 includes six condensation teeth 12 for description.

When the condensation tooth 12 is disposed, a structural shape of the condensation tooth 12 may be diversified, and a quantity of condensation channels 120 and a shape of the condensation channel 120 may also be diversified.

For example, as shown in FIG. 4, in an example provided in this application, the condensation tooth 12 is of a roughly rectangular plate structure. In the first direction, the condensation tooth 12 includes a first end (for example, a left end in FIG. 4) and a second end (for example, a right end in FIG. 4), and the first end is of a closed structure. The condensation tooth 12 includes three condensation channels 120 spaced apart from each other in the second direction, and the three condensation channels 120 all extend in the first direction. An end (for example, a right end in FIG. 4) of each condensation channel 120 extends to the second end, to facilitate communication with the evaporation cavity 110.

It should be noted that, during specific disposing, the condensation tooth 12 may include one condensation channel 120, or may include two or more condensation channels 120. When the condensation tooth 12 includes three or more condensation channels 120, a distance between two adjacent condensation channels 120 may be the same or may be different. This is not limited in this application.

During specific disposing, a cross-sectional shape and a size of the condensation channel 120 may also be diversified.

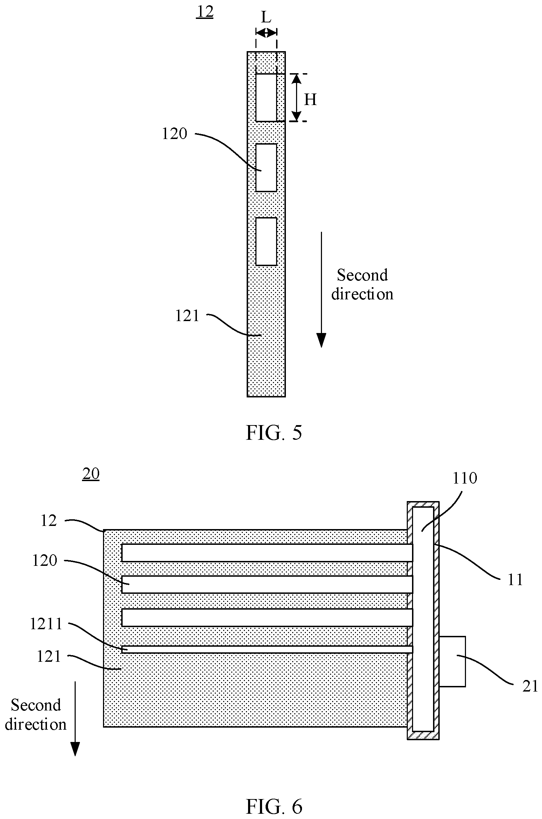

For example, as shown in FIG. 5, in an example provided in this application, a shape of a cross section perpendicular to an extension direction of the condensation channel 120 is a rectangle, and a ratio of a size H of the condensation channel 120 in the second direction to a size L of the condensation channel 120 in the thickness direction is greater than or equal to 3. In this way, the condensation tooth 12 has good cooling performance. Specifically, refer to FIG. 4. During actual use, the gaseous cooling working medium enters the condensation channel 120 from the second end (for example, the right end in FIG. 4), and flows toward the first end (for example, the left end in FIG. 4). In addition, in a circulation process, the gaseous cooling working medium is cooled and liquefied. Under an action of gravity, the liquid cooling working medium is deposited at the bottom of the condensation channel 120, and finally flows back from the right end of the condensation channel 120 to the evaporation cavity 110, to implement circulation of the cooling working medium.

In the example provided in this application, the ratio of the height size H of the condensation channel 120 to the width size L of the condensation channel 120 is appropriately set, so that effective circulation space can be provided for the gaseous cooling working medium, and the gaseous cooling working medium can effectively flow in the condensation channel 120. In addition, effective circulation space can be further provided for the liquid cooling working medium, so that the liquid cooling working medium can be effectively discharged from the condensation channel 120. In this way, good cooling efficiency is achieved.

During specific disposing, the ratio of the size H of the condensation channel 120 in the second direction to the size L of the condensation channel 120 in the thickness direction may be specifically 3, 3.1, 3.5, 4, or the like. During actual application, the ratio may be appropriately set based on an actual requirement. Details are not described herein.

In addition, it should be noted that, in the foregoing example, an example in which the cross section of the condensation channel 120 is a rectangle is used for description. In another example, the cross section of the condensation channel 120 may alternatively be an ellipse, a polygon, or another irregular shape. During actual application, the specific shape and the size of the condensation channel 120 may be appropriately selected and set based on an actual requirement. For example, a hydraulic diameter of the condensation channel 120 may be greater than or equal to 2 mm, so that good condensation, backflow, and the like of the cooling working medium can be implemented in the condensation channel 120. The hydraulic diameter is a ratio of four times an area to a circumference in the cross section of the condensation channel 120. During specific disposing, parameters such as the size and the shape of the condensation channel 120 may be appropriately set based on an actual requirement. Details are not described herein.

When the condensation tooth 12 is manufactured, the condensation tooth 12 may be manufactured through a process like plate bending molding or welding, or may be manufactured in a manner for manufacturing a profile, for example, hot pressing molding, cold drawing molding, cold extrusion molding, or hot extrusion molding. A specific manufacturing process of the condensation tooth 12 is not limited in this application.

In addition, during specific disposing, the solid region 121 may be of a solid structure, in other words, the solid region 121 includes only a solid material. In another example, the solid region 121 may alternatively be of a hollow structure.

For example, as shown in FIG. 6, in an example provided in this application, the solid region 121 may further include a cavity 1211, and an end (a right end in FIG. 6) of the cavity 1211 extends to the second end of the condensation tooth 12. A weight and material consumption of the condensation tooth 12 can be effectively reduced by disposing the cavity 1211. In addition, the cavity 1211 may further accommodate a cooling working medium. When a liquid level of the liquid cooling working medium in the evaporation cavity 110 is lower than that in the cavity 1211, the cooling working medium in the cavity 1211 may be supplemented to the evaporation cavity 110. In this way, a problem of insufficiency of the cooling liquid can be effectively reduced or avoided.

In the example provided in FIG. 6, an example in which the cavity 1211 is an open cavity is used for description. However, in another example, the cavity 1211 may alternatively be a closed cavity located inside the solid region 121. Alternatively, when the cavity 1211 is an open cavity, the cavity 1211 may communicate with the outside, but not communicate with the evaporation cavity 110.

During specific disposing, parameters such as a quantity of cavities 1211, and a cross-sectional shape and a length of the cavity 1211 may be appropriately set based on an actual requirement. Details are not described herein.

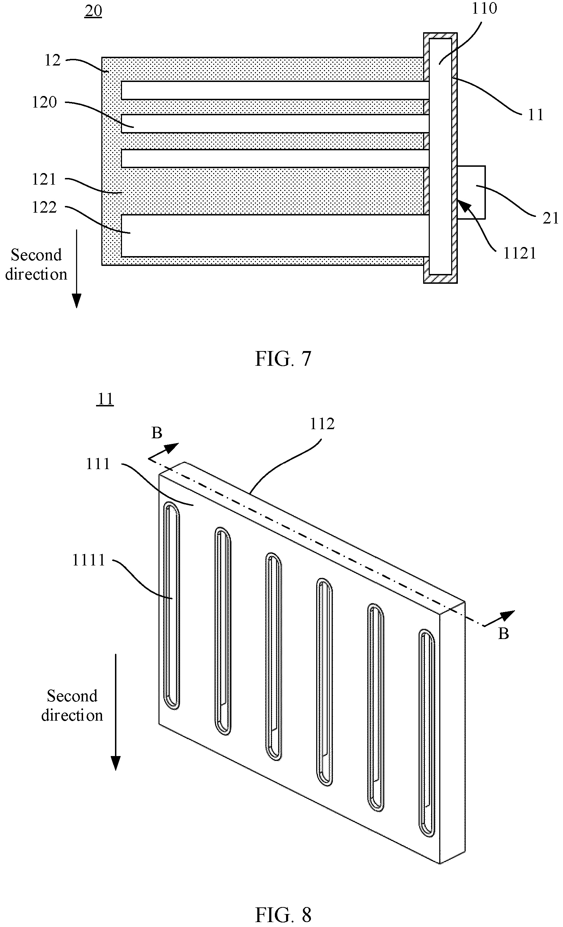

In addition, as shown in FIG. 7, in another example provided in this application, the condensation tooth 12 further has a liquid collection cavity 122. The liquid collection cavity 122 is located on a side that is of the solid region 121 and that is away from the condensation channel 120, and the liquid collection cavity 122 communicates with the evaporation cavity 110. For example, during actual use, the liquid collection cavity 122 may be located on a lower side of the solid region 121, and the condensation channel 120 is located on the upper side of the solid region 121. The liquid collection cavity 122 may accommodate a cooling working medium. When the liquid level of the liquid cooling working medium in the evaporation cavity 110 is lower than that in the liquid collection cavity 122, the cooling working medium in the liquid collection cavity 122 may be supplemented to the evaporation cavity 110. In this way, the problem of the insufficiency of the cooling liquid can be effectively reduced or avoided.

In addition, a weight and material costs of the condensation tooth 12 can also be effectively reduced by disposing the liquid collection cavity 122. Alternatively, during actual application, when the liquid level of the liquid cooling working medium in the liquid collection cavity 122 is low, the gaseous cooling working medium may also flow to the liquid collection cavity 122, and is condensed and liquefied in the liquid collection cavity 122. This can effectively improve heat dissipation performance of the heat sink 10.

During specific disposing, parameters such as a quantity of liquid collection cavities 122, and a cross-sectional shape and a length of the liquid collection cavity 122 may be appropriately set based on an actual requirement. Details are not described herein.

When the evaporator 11 is disposed, a structure type of the evaporator 11 may also be diversified.

For example, as shown in FIG. 8, in an example provided in this application, an overall appearance of the evaporator 11 is a rectangular plate structure. The evaporator 11 includes a first side wall 111 and a second side wall 112. The first side wall 111 and the second side wall 112 are disposed opposite to each other in a horizontal direction, and the evaporation cavity 110 is located between the first side wall 111 and the second side wall 112. A first surface 1001 of the second side wall 112 may be attached to the power module, so that heat of the power module can be effectively transferred to the evaporator 11. A second surface 1002 of the first side wall 111 is configured to connect to the condensation tooth 12. The first side wall 111 has a plurality of through holes 1111 that penetrate into the evaporation cavity 110. Refer to FIG. 7 and FIG. 8. After a right end of the condensation tooth 12 is connected to the first side wall 111 of the evaporator 11, the condensation channel 120 can communicate with the through hole 1111, so that the condensation channel 120 communicates with the evaporation cavity 110. During specific disposing, the condensation tooth 12 and the evaporator 11 may be fastened through welding, bonding, or the like, or may be fastened in another manner. This is not limited in this application.

In addition, in some examples, a first positioning structure may alternatively be disposed on the first side wall 111, and a second positioning structure may be disposed at the right end of the condensation tooth 12, to increase positioning precision between the condensation tooth 12 and the evaporator 11. For example, the first positioning structure may be specifically a groove or a protrusion, and the second positioning structure may be specifically a protrusion or a groove. Effective positioning between the condensation tooth 12 and the evaporator 11 may be implemented through insertion fitting between the groove and the protrusion. During specific disposing, specific structure types of the first positioning structure and the second positioning structure may be appropriately set based on an actual requirement. This is not limited in this application.

It may be understood that, in another example, the entire evaporator 11 may alternatively be in a polyhedron like a cube, or may be in another irregular shape. During actual application, a structural shape of the evaporator 11 may be appropriately set and adjusted. Details are not described herein.

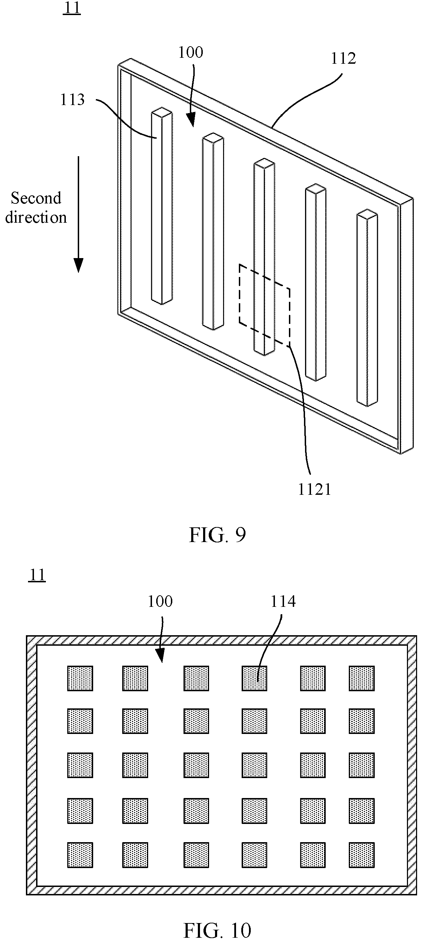

In addition, refer to FIG. 8 and FIG. 9. In the example provided in this application, the evaporation cavity 110 further includes a thermally conductive rib 113. One side of the thermally conductive rib 113 is connected to the first side wall 111, and the other side is connected to the second side wall 112. Heat transfer between the first side wall 111 and the second side wall 112 can be implemented through the thermally conductive rib 113, so that heat of the second side wall 112 can be efficiently transferred to the first side wall 111, and dissipated through the first side wall 111. In addition, the thermally conductive rib 113 is provided, so that heat of the second side wall 112 can be conducted to the first side wall 111 in a heat transfer manner, to effectively improve heat dissipation efficiency of the second side wall 112 and temperature uniformity of the evaporator 11. The condensation tooth 12 is located on the first side wall 111, and heat of the first side wall 111 can be effectively conducted to the condensation tooth 12 in a heat transfer manner. The condensation tooth 12 can provide a large heat dissipation area. Therefore, heat dissipation performance of the heat sink 10 can be effectively improved.

When the thermally conductive rib 113 is disposed, shapes, a specified quantity, and a position layout of thermally conductive ribs 113 may be diversified.

For example, as shown in FIG. 9, in an example provided in this application, the heat sink 10 includes five thermally conductive ribs 113, and each thermally conductive rib 113 is in a straight strip shape extending in the second direction. In addition, the plurality of thermally conductive ribs 113 are sequentially spaced apart from each other. The thermally conductive rib 113 is disposed, so that structural strength and the temperature uniformity of the evaporator 11 can be effectively improved.

Specifically, the thermally conductive rib 113 is connected between the first side wall 111 and the second side wall 112, and can effectively connect and support the first side wall 111 and the second side wall 112. When the first side wall 111 or the second side wall 112 of the evaporator 11 is subject to an external squeezing force, the thermally conductive rib 113 can effectively resist the external squeezing force, to improve pressure resistance performance of the evaporator 11. In addition, the thermally conductive rib 113 is fastened to the first side wall 111 and the second side wall 112. When pressure in the evaporation cavity 110 is large, the thermally conductive rib 113 can effectively connect the first side wall 111 and the second side wall 112, to prevent the first side wall 111 and the second side wall 112 from an adverse situation like protrusion, to effectively improve explosion-proof performance of the evaporator 11.

It may be understood that, during specific disposing, a connection between the thermally conductive rib 113 and the first side wall 111 or the second side wall 112 may alternatively be disposed in a non-fastening manner.

For example, the thermally conductive rib 113 may be fastened to the first side wall 111 and abut against the second side wall 112. Alternatively, the thermally conductive rib 113 may be fastened to the second side wall 112 and abut against the first side wall 111. Alternatively, the thermally conductive rib 113 may abut against both the first side wall 111 and the second side wall 112. The thermally conductive rib 113 may be effectively fastened in the evaporation cavity 110 by using a squeezing force between the first side wall 111 and the second side wall 112, so that an adverse situation like position deviation of the thermally conductive rib 113 is avoided.

In addition, heat of the second side wall 112 can be effectively transferred to the first side wall 111 through the thermally conductive rib 113, so that a temperature difference between the second side wall 112 and the first side wall 111 can be effectively reduced. In this way, temperature uniformity of the evaporator 11 in the horizontal direction can be improved. In addition, the heat may be further transferred in a length direction of the thermally conductive rib 113. Therefore, heat of a local hot spot can be effectively diffused, and the temperature uniformity of the evaporator 11 can be further improved.

During manufacturing, the thermally conductive rib 113 may be a mechanical member that is independently manufactured and formed, and then the thermally conductive rib 113 is fastened in the evaporation cavity 110. Alternatively, the thermally conductive rib 113 and the first side wall 111 or the thermally conductive rib 113 and the second side wall 112 may be an integrally formed mechanical member. A manufacturing manner of the evaporator 11 is not limited in this application.

In addition, as shown in FIG. 9, in the example provided in this application, in the length direction of the thermally conductive rib 113, neither of two ends of the thermally conductive rib 113 extends to an inner wall of the evaporation cavity 110, so that the thermally conductive rib 113 can be prevented from significantly blocking normal flow of the cooling working medium. For example, the thermally conductive rib 113 can divide the evaporation cavity 110 to some extent, and a flow channel structure can be formed between two adjacent thermally conductive ribs 113. Because neither of the two ends of the thermally conductive rib 113 extends to the inner wall of the evaporation cavity 110, flow channel structures on two sides of the thermally conductive rib 113 communicate with each other. That is, the cooling working medium located on two sides of the thermally conductive rib 113 can effectively flow from the two ends of the thermally conductive rib 113, to effectively ensure effective flow of the cooling working medium in the entire evaporation cavity 110. Specifically, the gaseous cooling working medium may effectively flow in space between the top of the thermally conductive rib 113 and the inner wall of the evaporation cavity 110, and the liquid cooling working medium can implement effective circulation in space between the bottom of the thermally conductive rib 113 and the inner wall of the evaporation cavity 110.

In another example, two ends of the thermally conductive rib 113 may alternatively extend to an inner wall of the evaporation cavity 110, and a structure like a notch may be disposed in a middle part of the thermally conductive rib 113 or at another position, so that the cooling working medium located on two sides of the thermally conductive rib 113 can flow through the notch, to ensure effective circulation of the cooling working medium.

In addition, in another example, the thermally conductive rib 113 may alternatively be of a long strip structure like a curve shape or a fold line shape. During actual application, a shape of the thermally conductive rib 113 may be flexibly set and adjusted based on an actual requirement.

As shown in FIG. 9, in the example provided in this application, a region in which the evaporator 11 is attached to the power module 21 may be defined as a thermally conductive region 1121. During specific disposing, a vertical projection of the thermally conductive rib 113 on the second side wall 112 may be located in the thermally conductive region 1121, so that heat of the thermally conductive region 1121 can be effectively transferred to the first side wall 111 through the thermally conductive rib 113.

In addition, as shown in FIG. 7, in the example provided in this application, in the first direction, a projection of the solid region 121 of the condensation tooth 12 on the evaporator 11 overlaps the thermally conductive region 1121. Alternatively, it may be understood that the projection of the power module 21 in the first direction overlaps the solid region 121. The thermally conductive region 1121, the thermally conductive rib 113, and the solid region 121 can form a short heat transfer path. Heat of the thermally conductive region 1121 can be transferred to the second side wall 112 through the thermally conductive rib 113, and heat of the second side wall 112 can be effectively transferred to the condensation tooth 12 through the solid region 121, so that heat transfer efficiency is high. This can effectively improve heat dissipation efficiency of the heat sink 10.

In the foregoing example, an example in which the thermally conductive rib 113 is in a long strip shape is used for description. In another example, the thermally conductive rib 113 may alternatively be in a block shape.

Specifically, as shown in FIG. 10, in the example provided in this application, the evaporator 11 includes a plurality of protrusions 114, shapes and sizes of the protrusions 114 are basically the same, and the plurality of protrusions 114 are evenly arranged in an array.

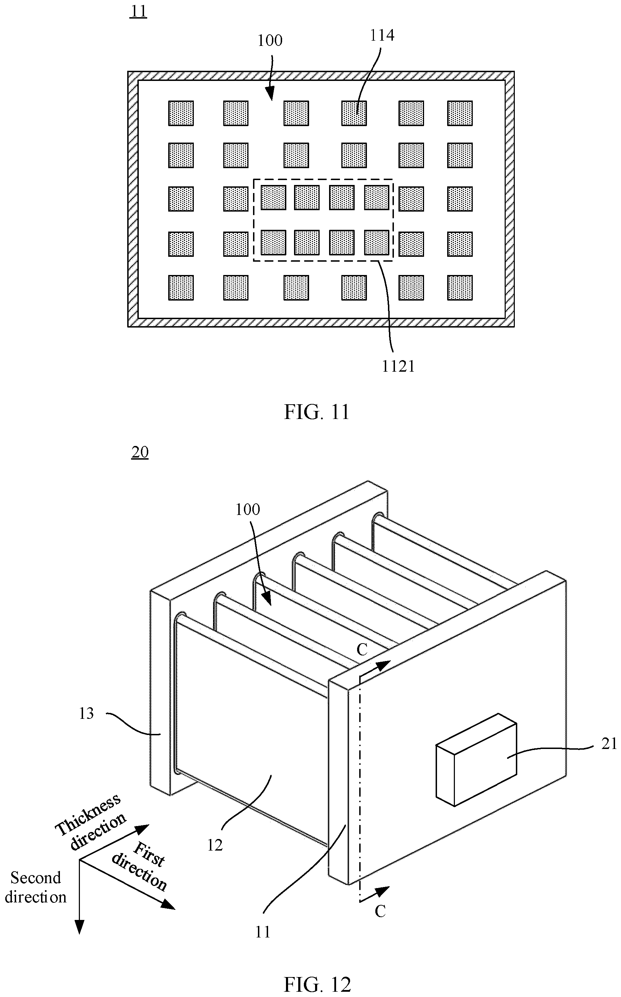

Alternatively, as shown in FIG. 11, in another example provided in this application, a layout density of the protrusions 114 in a region corresponding to the thermally conductive region 1121 is high, and a layout density of the protrusions 114 in another region is low. In other words, heat of the thermally conductive region 1121 can be effectively transferred to the second side wall 112 through the densely arranged protrusions 114. In this way, good heat transfer efficiency can be achieved.

In addition, the protrusion 144 can further enable the liquid cooling working medium to boil in the evaporation cavity 110, so that gasification efficiency of the cooling working medium can be effectively improved, to improve heat dissipation performance of the heat sink 10. In addition, in some embodiments, sandblasting, sintering, or the like may alternatively be used to perform coarsening, hole forming, or the like on the inner wall of the evaporation cavity 110, to enable the liquid cooling working medium to boil in the evaporation cavity 110. During specific disposing, the coarsening or hole processing may be performed on the entire inner wall of the evaporation cavity 110. Alternatively, the coarsening or hole processing may be performed only in an orthographic projection region of the thermally conductive region 1121. Alternatively, the coarsening or hole processing may be performed on a surface of the protrusion 114. Details are not described herein.

It may be understood that, during actual application, a shape, a size, and location distribution of the protrusion 114 may be appropriately set based on an actual requirement. Details are not described herein.

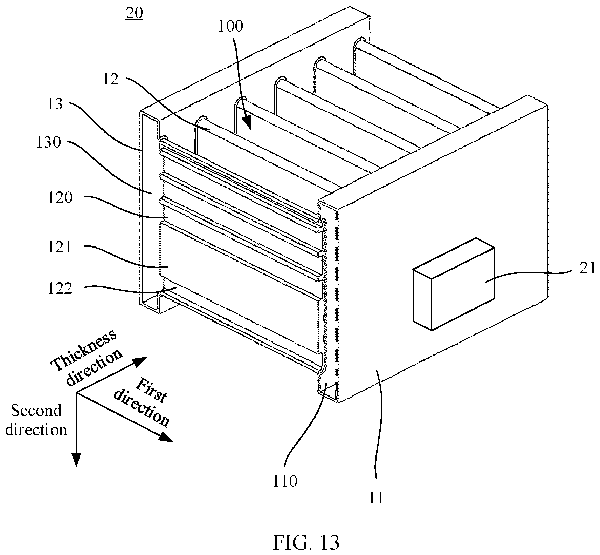

In addition, as shown in FIG. 12 and FIG. 13, in the example provided in this application, the heat sink 10 further includes a confluence plate 13, the confluence plate 13 is disposed opposite to the evaporator 11, and the plurality of condensation teeth 12 are connected between the evaporator 11 and the confluence plate 13. The confluence plate 13 has a condensation confluence cavity, and the condensation channel 120 communicates with the condensation confluence cavity.

In the example provided in this application, a structure of the confluence plate 13 is basically the same as that of the evaporator 11. Simply speaking, an overall appearance of the confluence plate 13 is a rectangular plate-shaped structure, the confluence plate 13 has the condensation confluence cavity 130, and the condensation confluence cavity 130 communicates with each condensation channel 120.

It should be noted that, in the foregoing example, when the heat sink 10 does not include the confluence plate 13, the condensation channel 120 and the liquid collection cavity 122 in the condensation tooth 12 are in a structural form in which one end is closed and the other end is open.

After the heat sink 10 includes the confluence plate 13, the condensation channel 120 in the condensation tooth 12 is in a structural form in which two ends are open, that is, one end of the condensation channel 120 communicates with the evaporation cavity 110, and the other end communicates with the condensation confluence cavity 130. One end of the liquid collection cavity 122 communicates with the evaporation cavity 110, and the other end communicates with the condensation confluence cavity 130.

During specific application, the specific structure of the confluence plate 13 may be disposed the same as or similar to that of the evaporator 11. In addition, a connection manner between the confluence plate 13 and the condensation tooth 12 may also be appropriately set with reference to a connection manner between the evaporator 11 and the condensation tooth 12. Details are not described herein.

In the example provided in this application, the confluence plate 13 is disposed to communicate with the plurality of condensation channels 120, so that the liquid cooling working medium condensed in the condensation channel 120 can be discharged into the condensation confluence cavity 130. This can effectively prevent the liquid cooling working medium from accumulating in the condensation channel 120. In this way, sufficient space can be provided for another cooling working medium.

In addition, the condensation confluence cavity 130 can accommodate a large amount of liquid cooling working medium, to help reduce a size of the evaporator 11. Alternatively, it may be understood that, during actual application, to ensure the heat dissipation performance of the heat sink 10, a large evaporation cavity 110 needs to be provided in the evaporator 11 to accommodate a sufficient amount of the cooling working medium, to avoid an adverse situation like dry burning. In an example provided in this application, the condensation confluence cavity 130 is provided, so that effective accommodation space can be provided for the liquid cooling working medium, and the liquid cooling working medium can be effectively transferred to the evaporation cavity 110. Therefore, an adverse situation like dry burning of the evaporator 11 can be effectively prevented, and the size of the evaporator 11 can be reduced.

It should be noted that, in the foregoing example, the evaporation cavity 110 of the evaporator 11 includes a structure like the thermally conductive rib 113 or the protrusion 114. When the confluence plate 13 is disposed, the condensation confluence cavity 130 of the confluence plate 13 may also include a structure like a thermally conductive rib 113 or a protrusion 114.

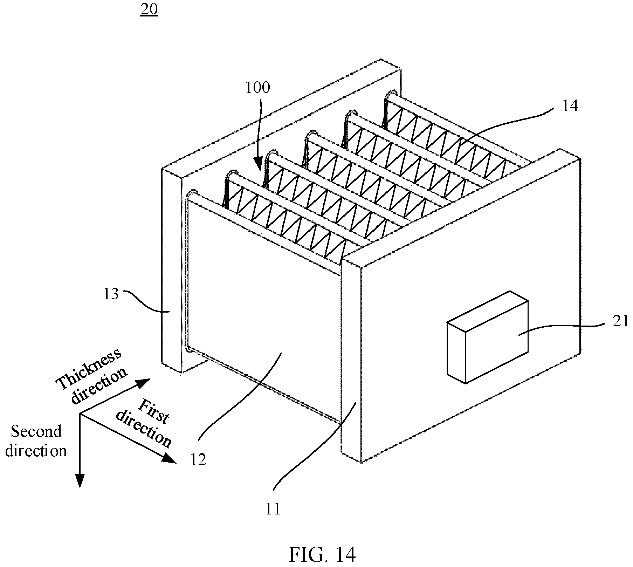

In addition, as shown in FIG. 14, in an example provided in this application, the heat sink 10 further includes a heat dissipation fin 14. The heat dissipation fin 14 is located in the airflow channel 100, and is connected to the outer surface of the condensation tooth 12. The heat of the condensation tooth 12 may be effectively transferred to the heat dissipation fin 14 through heat conduction. The heat dissipation fin 14 has a large heat exchange area, and the air flowing through the airflow channel 100 can quickly take away heat of the heat dissipation fin 14, to effectively improve condensation efficiency of the cooling working medium in the condensation channel 120.

During actual application, the heat dissipation fin 14 may be fastened between two adjacent condensation teeth 12, so that overall integration and structural strength of an assembly of condensation teeth 12 can be effectively improved. During actual application, the assembly of the condensation teeth 12 may be assembled as a whole.

During specific disposition, a structure type of the heat dissipation fin 14 may be diversified.

For example, as shown in FIG. 14, the heat dissipation fin 14 may be of a bent sheet structure. Certainly, in another example, the heat dissipation fin 14 may alternatively be of a flat sheet structure or the like. A specific structural shape of the heat dissipation fin 14 is not limited in this application.

During actual application, the heat dissipation fin 14 may be independently manufactured and formed, and then fastened to the condensation tooth 12 through welding or the like.

Alternatively, the heat dissipation fin 14 and the condensation tooth 12 may be manufactured by using an integrated molding process.

During actual application, a specific structure type and a manufacturing manner of the heat dissipation fin 14 may be appropriately selected and adjusted. Details are not described herein.

In addition, during specific manufacturing, a structural composition of the entire heat sink 10 may also be diversified.

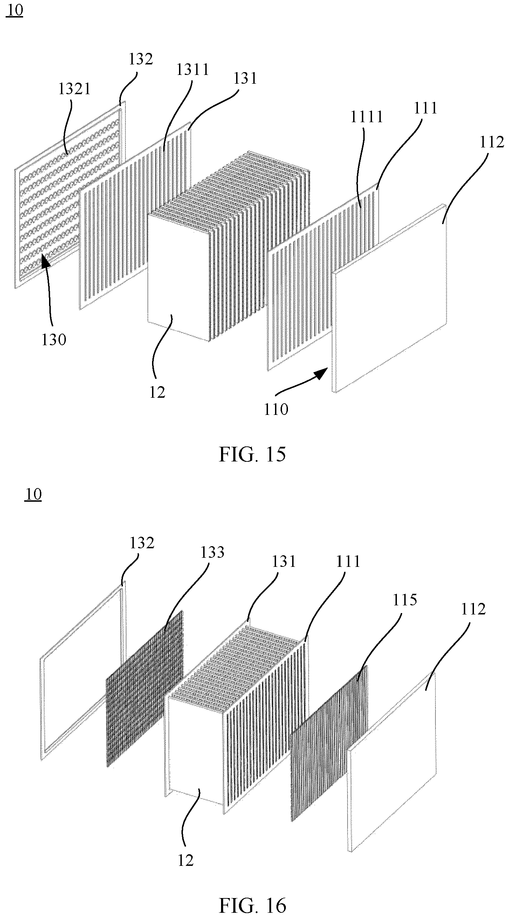

For example, as shown in FIG. 15, in an example provided in this application, the first side wall 111 and the second side wall 112 of the evaporator 11 are two mutually independent mechanical parts. A side that is of the second side wall 112 and that faces the first side wall 111 has a groove (not shown in the figure), and the first side wall 111 covers the groove of the second side wall 112 to form the evaporation cavity 110. The first side wall 111 has a narrow and long through hole 1111, to facilitate interconnection with the condensation channel in the condensation tooth 12. The first side wall 131 and the second side wall 132 of the confluence plate 13 are two mutually independent mechanical parts. A side that is of the second side wall 132 and that faces the first side wall 131 has a groove, and the first side wall 131 covers the groove of the second side wall 132, to form the condensation confluence cavity 130. The first side wall 131 has a narrow and long through hole 1311, to facilitate interconnection with the condensation channel in the condensation tooth 12. In addition, a protrusion 1321 is formed in the groove of the second side wall 132. Certainly, a protrusion (not shown in the figure) is also formed in the groove of the second side wall 112.

During specific disposing, the first side wall 111 and the second side wall 112 may be fastened through welding or the like. Correspondingly, the first side wall 131 and the second side wall 132 may be fastened through welding or the like. This is not limited in this application.

During specific disposing, the protrusion 1321 and the second side wall 132 may be of an integrated structure, or the protrusion 1321 and the second side wall 132 may be separately formed, and then the protrusion 1321 is fastened in the groove of the second side wall 132 through welding or the like.

Alternatively, in some examples, the protrusion may be replaced with a fin structure.

For example, as shown in FIG. 16, in an example provided in this application, the evaporator 11 includes a meshed fin structure 115, and the confluence plate 13 includes a meshed fin structure 133. The fin structure 115 may be fastened to the first side wall 111 or the second side wall 112 through welding or the like. Correspondingly, the fin structure 115 may be fastened to the first side wall 131 or the second side wall 132 through welding or the like.

In summary, during actual application, a specific structural form and a composition manner of the heat sink 10 may be appropriately set based on an actual requirement. Details are not described herein.

In addition, in the foregoing example, an example in which the power conversion apparatus 20 includes one heat sink 10 is used for description. However, in another example, the power conversion apparatus 20 includes two or more heat sinks 10.

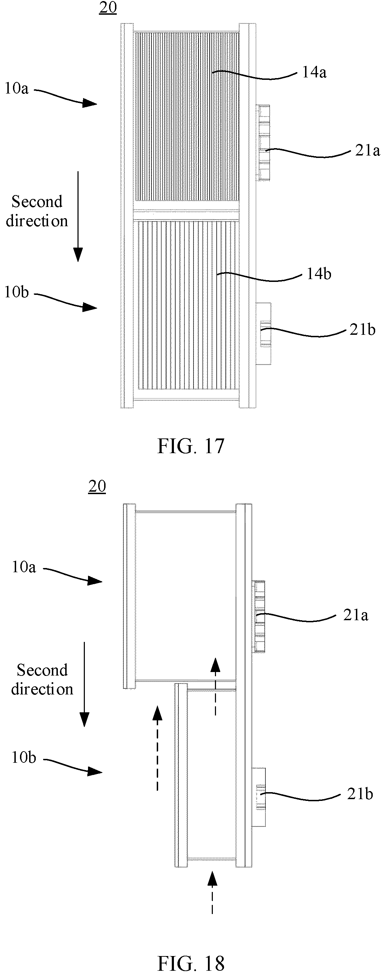

For example, as shown in FIG. 17, in an example provided in this application, the power conversion apparatus 20 includes two heat sinks: a first heat sink 10a and a second heat sink 10b. The first heat sink 10a is configured to cool a power module 21a, the second heat sink 10b is configured to cool a power module 21b. Structures of the first heat sink 10a and the second heat sink 10b are basically the same as the structure of the heat sink 10 shown in FIG. 14. Details are not described herein again. The first heat sink 10a and the second heat sink 10b are stacked in the second direction. For example, during actual use, the first heat sink 10a may be located on an upper side of the second heat sink 10b. External air may enter an airflow channel of the second heat sink 10b from the bottom of the second heat sink 10b, be discharged from the top of the second heat sink 10b to an airflow channel of the first heat sink 10a, and finally be discharged from the top of the first heat sink 10a.

In addition, as shown in FIG. 17, in the example provided in this application, the airflow channel of the first heat sink 10a includes first heat dissipation fins 14a, the airflow channel of the second heat sink 10b includes second heat dissipation fins 14b, and a layout density of the first heat dissipation fins 14a is greater than a layout density of the second heat dissipation fins 14b. After the layout density of the second heat dissipation fins 14b is small, resistance of air flowing through the second heat dissipation fin 14b can be decreased, so that air still has a high circulation speed when flowing through the first heat dissipation fin 14a. In addition, after the arrangement density of the first heat dissipation fins 14a is large, a heat exchange area between the first heat dissipation fin 14a and air can be increased, and heat dissipation efficiency of the first heat sink 10a can be ensured. In addition, when air sequentially flows through the first heat sink 10a and the second heat sink 10b, a temperature gradually increases. Therefore, when the layout density of the first heat dissipation fins 14a is greater than the layout density of the second heat dissipation fins 14b, temperature uniformity between the first heat sink 10a and the second heat sink 10b can be further ensured.

In addition, as shown in FIG. 18, in another example provided in this application, a projection of the airflow channel of the first heat sink 10a in the second direction is greater than a projection of the airflow channel of the second heat sink 10b in the second direction. That is, air flowing through the airflow channel of the first heat sink 10a may be divided into two parts. A part of air flows through the airflow channel of the second heat sink 10b and then flows through the airflow channel of the first heat sink 10a. The other part of air directly flows from the outside through the airflow channel of the first heat sink 10a. This can effectively ensure heat dissipation performance of the first heat sink 10a, and can ensure temperature uniformity between the first heat sink 10a and the second heat sink 10b.

In addition, in another example, the power conversion apparatus 20 may further include three or more heat sinks.

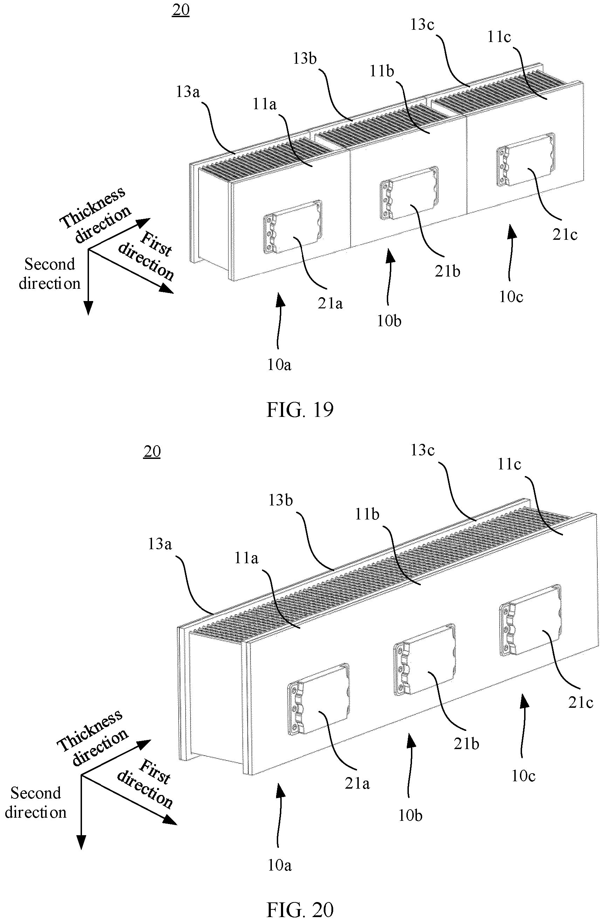

For example, as shown in FIG. 19, in an example provided in this application, the power conversion apparatus 20 includes three heat sinks: a heat sink 10a, a heat sink 10b, and a heat sink 10c. The three heat sinks are arranged in the first direction. The heat sink 10a is configured to cool a power module 21a, the heat sink 10b is configured to cool a power module 21b, and the heat sink 10c is configured to cool a power module 21c. During specific disposing, the three heat sinks are independent of each other.

Alternatively, as shown in FIG. 20, the three heat sinks may be integrated. Simply speaking, an evaporator 11a, an evaporator 11b, and an evaporator 11c in the heat sink 10a, the heat sink 10b, and the heat sink 10c may be of an integrated structure, and a confluence plate 13a, a confluence plate 13b, and a confluence plate 13c may be of an integrated structure. This can effectively improve integration. In addition, evaporation cavities in the three evaporators may be independent of each other, or may communicate with each other. Correspondingly, condensation confluence cavities in the three confluence plates may be independent of each other, or may communicate with each other.

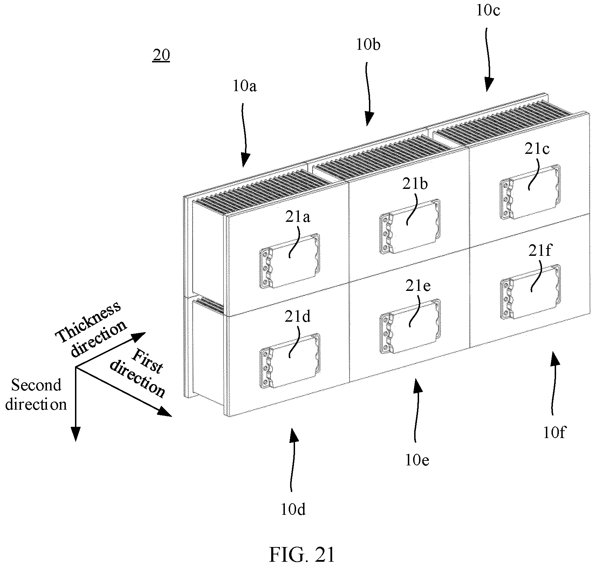

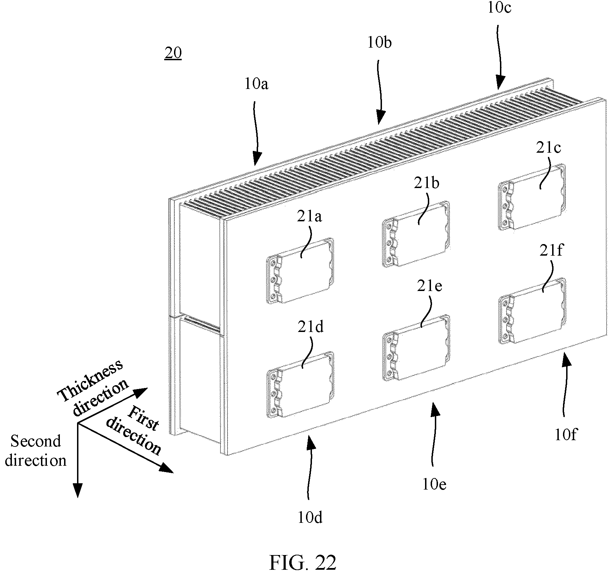

Alternatively, as shown in FIG. 21 and FIG. 22, in the example provided in this application, the power conversion apparatus 20 includes six heat sinks: a heat sink 10a, a heat sink 10b, a heat sink 10c, a heat sink 10d, a heat sink 10e, and a heat sink 10f. The heat sink 10a is configured to cool a power module 21a, the heat sink 10b is configured to cool a power module 21b, the heat sink 10c is configured to cool a power module 21c, the heat sink 10d is configured to cool a power module 21d, the heat sink 10e is configured to cool a power module 21e, and the heat sink 10f is configured to cool a power module 21f.

During specific disposing, the six heat sinks may be independent of each other, or the six heat sinks may be integrated. Details are not described herein.

In addition, during specific application, the heat sinks may be independently used in a plurality of different types of electronic devices, to dissipate heat for the electronic devices. Alternatively, the heat sinks may be integrated into an electronic device for application.

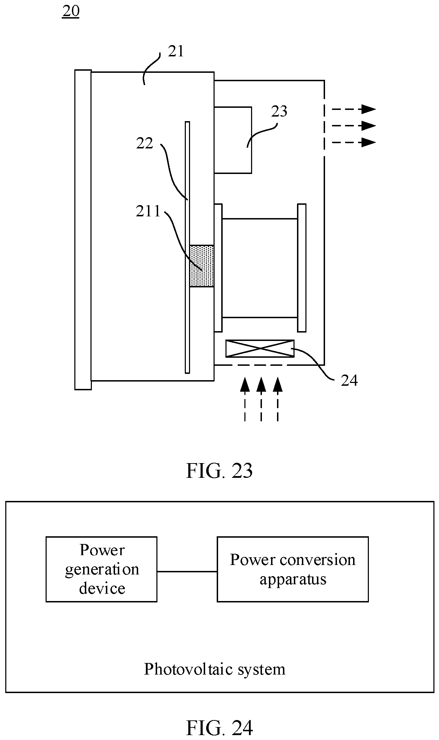

For example, as shown in FIG. 23, in the example provided in this application, the heat sink 10 may be used in the power conversion apparatus 20. The power conversion apparatus 20 may further include components such as an inductor 23 and the power module 21. The power module 21 includes a circuit board 22 and a power component 211. The power component 211 is disposed on a side of the circuit board 22 and is electrically connected to a conductive line in the circuit board 22. Certainly, during actual application, the inductor 23 may alternatively be connected to a conductive line in the circuit board 22, to implement a function like filtering. The power component 211 may specifically include components configured to implement power conversion, for example, a power transistor and a power conversion circuit. Alternatively, the power conversion apparatus 20 may be specifically a rectifier, an inverter, or the like.

In addition, during specific disposing, the power conversion apparatus 20 may further include a fan 24. The fan 24 may be located on a lower side of the heat sink 10, and is configured to generate an airflow that flows through the airflow channel of the heat sink 10, to improve heat dissipation efficiency of the heat sink 10.

During actual application, the power conversion apparatus 20 may be used in a plurality of scenarios in which electric energy needs to be adjusted and controlled.

For example, as shown in FIG. 24, embodiments of this application further provide a photovoltaic system. The photovoltaic system may include a power generation device and a power conversion apparatus. The power conversion apparatus may be connected to the power generation device, and is configured to effectively process electric energy generated by the power generation device, to output processed electric energy to the outside.

During actual application, the power generation device may be specifically a solar panel. The solar panel may generate a direct current, and the power conversion apparatus may convert the direct current generated by the solar panel into an alternating current and then output the alternating current to the outside.

Certainly, in another example, the photovoltaic system may further include a battery, a battery management system, and the like. In addition, during actual application, the power conversion apparatus may be used in a plurality of scenarios in which electric energy needs to be adjusted and controlled. A specific application scenario of the power conversion apparatus is not limited in this application.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

"A plurality of" in this application refers to two or more than two. "And/or" describes an association relationship between associated objects and indicates that three relationships may exist. For example, A and/or B may indicate the following three cases: Only A exists, both A and B exist, and only B exists, where A and B may be singular or plural.

It may be understood that numerical symbols involved in embodiments of this application are differentiated merely for ease of description, but are not used to limit the scope of embodiments of this application. The sequence numbers of the foregoing processes do not mean execution sequences, and the execution sequences of the processes should be determined based on functions and internal logic of the processes.

## Claims

1. A power conversion apparatus, comprising a heat sink and a power module, wherein
the heat sink comprises a plurality of condensation teeth and an evaporator, and each condensation tooth extends in a first direction;
the plurality of condensation teeth are spaced apart from each other in a thickness direction of the condensation tooth, and an airflow channel in a second direction is provided between two adjacent condensation teeth, wherein the first direction, the second direction, and the thickness direction are all perpendicular to each other;
each condensation tooth has a condensation channel and a solid region, both the condensation channel and the solid region extend in the first direction, and the condensation channel is located on a side of the solid region in the second direction;
the evaporator has an evaporation cavity, and each condensation channel communicates with the evaporation cavity;
the evaporator has a first surface and a second surface that are opposite to each other, and both the first surface and the second surface are perpendicular to the first direction; and
an end of each condensation tooth in the first direction is connected to the first surface, the power module is attached to the second surface, and a projection of the power module in the first direction overlaps the solid region.

2. The power conversion apparatus according to claim 1, wherein in a cross section perpendicular to the first direction, a ratio of a size of the condensation channel in the second direction to a size of the condensation channel in the thickness direction is greater than or equal to 3.

3. The power conversion apparatus according to claim 1 or 2, wherein the solid region further has a cavity, and the cavity is a closed cavity, or the cavity communicates with the evaporation cavity.

4. The power conversion apparatus according to any one of claims 1 to 3, wherein the condensation tooth further has a liquid collection cavity, the liquid collection cavity is located on a side that is of the solid region and that is away from the condensation channel, and the liquid collection cavity communicates with the evaporation cavity.

5. The power conversion apparatus according to claim 4, wherein the evaporator comprises a first side wall and a second side wall, the first side wall and the second side wall are disposed opposite to each other in the first direction, and the evaporation cavity is located between the first side wall and the second side wall;
one end of the condensation tooth is connected to the first side wall, and the power module is attached to a surface of the second side wall; and
the evaporation cavity comprises a thermally conductive rib, one end of the thermally conductive rib is connected to the first side wall, and the other end is connected to the second side wall.

6. The power conversion apparatus according to claim 5, wherein a flow channel is formed between two adjacent thermally conductive ribs, and two adjacent flow channels communicate with each other.

7. The power conversion apparatus according to claim 6, wherein the thermally conductive rib is in a long strip shape and extends in the second direction; or the thermally conductive rib is a protrusion, and a plurality of protrusions are spaced from each other in the evaporation cavity.

8. The power conversion apparatus according to any one of claims 1 to 7, wherein the heat sink further comprises a heat dissipation fin, and the heat dissipation fin is located in the airflow channel and is connected to an outer surface of the condensation fin.

9. The power conversion apparatus according to any one of claims 1 to 8, wherein the heat sink further comprises a confluence plate, the confluence plate is disposed opposite to the evaporator, and the plurality of condensation teeth are connected between the evaporator and the confluence plate; and
the confluence plate has a condensation confluence cavity, and the condensation channel communicates with the condensation confluence cavity.

10. The power conversion apparatus according to any one of claims 1 to 9, wherein the power conversion apparatus comprises a plurality of heat sinks, and the plurality of heat sinks are disposed in the first direction and/or the second direction.

11. The power conversion apparatus according to claim 10, wherein the plurality of heat sinks comprise a first heat sink and a second heat sink that are stacked in the second direction; and
a projection of an airflow channel of the first heat sink in the second direction is greater than a projection of an airflow channel of the second heat sink in the second direction.

12. The power conversion apparatus according to claim 10 or 11, wherein the plurality of heat sinks comprise the first heat sink and the second heat sink that are stacked in the second direction;
the first heat sink further comprises first heat dissipation fins, and the first heat dissipation fin is located in the airflow channel of the first heat sink; and
the second heat sink further comprises second heat dissipation fins, and the second heat dissipation fin is located in the airflow channel of the second heat sink, wherein
a layout density of the first heat dissipation fins is greater than a layout density of the second heat dissipation fins.

13. The power conversion apparatus according to any one of claims 1 to 12, wherein the evaporator has a first positioning protrusion or a first positioning groove, the condensation tooth has a second positioning groove or a second positioning protrusion, and the first positioning protrusion is inserted into the second positioning groove, or the second positioning protrusion is inserted into the first positioning groove.

14. The power conversion apparatus according to any one of claims 1 to 13, wherein the power conversion apparatus is a rectifier or an inverter.

15. A heat sink, comprising a plurality of condensation teeth and an evaporator, wherein
each condensation tooth extends in a first direction;
the plurality of condensation teeth are spaced apart from each other in a thickness direction of the condensation tooth, and an airflow channel in a second direction is provided between two adjacent condensation teeth, wherein the first direction, the second direction, and the thickness direction are all perpendicular to each other;
each condensation tooth has a condensation channel and a solid region, both the condensation channel and the solid region extend in the first direction, and the condensation channel is located on a side of the solid region in the second direction;
the evaporator has an evaporation cavity, and each condensation channel communicates with the evaporation cavity;
the evaporator has a first surface and a second surface that are opposite to each other, and both the first surface and the second surface are perpendicular to the first direction; and
an end of each condensation tooth in the first direction is connected to the first surface.
